# EUROPEAN PATENT APPLICATION

(11) **EP 1 378 295 A2**
(43) Date of publication of application: **07.01.2004**
(21) Application number: 02256873.7
(22) Date of filing: 03.10.2002
(51) Int. Cl.: B05C 1/08, B05C 11/10, B05D 1/28

(54) **Resin coated carrier fabrication method and the related apparatus for the fabrication**

(30) Priority: 04.07.2002 CN 02141112
(71) Applicant: Ultratera Corporation, Hsin-Chu (TW)
(72) Inventor: Yu, Ching-I, Bade City, Taoyuan (TW); Chih, Lang-Ching, Gueishan Shiang, Taoyuan (TW); Liu, Kang-Tsun, Junan Jen, Miaoli (TW); Yen, Kung-Ming, Pingjen City, Taoyuan (TW)
(74) Representative: O'Connell, David Christopher

(57) **Abstract**

A resin coated carrier fabrication method and the related apparatus (10) in which a metered material feeder (16) is controlled to apply a bonding agent (18) to the periphery of a continuously rotated material-transferring cylinder (14) subject to a predetermined thickness and simultaneously a tape of carrier (42) is extended over an impression cylinder (30), and then a driving mechanism is controlled to adjust the gap between the material-transferring cylinder (14) and the impression cylinder (30) for enabling the bonding agent (18) to be transferred to the tape of carrier (42), leaving a blank area around the applied layer of bonding agent (18) on the tape of carrier (42).

## Description

### BACKGROUND OF THE INVENTION

### 1. Field of the Invention:

The present invention relates to the fabrication of a resin coated carrier for making a printed circuit board and, more particularly to a resin coated carrier fabrication method practical for making a resin coated carrier having a layer of resin and a blank area surrounding the layer of resin. The invention relates also to the apparatus for the application of the method.

### 2. Description of the Related Art:

A resin coated carrier for making a printed circuit board according to the prior art is generally comprised of a carrier obtained from, for example, copper foil, and a layer of resin coated on the carrier. The resin coated copper foil thus obtained can be adhered to a substrate for processing into a printed circuit board through a series of procedures including exposure and etching. PET may also be used as a carrier instead of copper foil.

Either material is used for the carrier, the carrier is cut into a tape. After one side of the carrier has been coated with a layer of bonding agent (resin), the resin coated carrier is cut into equal pieces subject to the size of the substrate. Thereafter, two impression boards are pressed together keeping the resin coated carrier and the substrate sandwiched therebetween. When pressing the impression boards against each other, the resin is formed to disperse and to partially flow out of the resin coated carrier. The resin will attach to the surface of the impression boards which is very difficult to remove. In order to facilitate removal of the overflow of resin, a release film may be added between the resin coated carrier and the lens board at each side for absorbing the overflow of resin. The release film is thrown away after its service. However, an additional mechanism must be installed to control loading and removal of release films during the PC board manufacturing process. The use of such a mechanism complicates the PC board manufacturing process, and relatively increases the PC board manufacturing cost.

### SUMMARY OF THE INVENTION

The present invention has been accomplished under the circumstances in view. It is the main object of the present invention to provide a resin coated carrier fabrication method and the related apparatus for the fabrication, which is practical for fabricating a resin coated carrier having a layer of resin of uniform thickness and a blank area surrounding the layer of resin that eliminates the aforesaid resin overflow problem.

It is another object of the present invention to provide a resin coated carrier fabrication method and the related apparatus for the fabrication, which is practical for fabricating an inexpensive resin coated carrier that is easy to use.

To achieve these and other objects of the present invention, the resin coated carrier fabrication method comprises the steps of: (a) applying a layer of bonding agent to a periphery of a continuously rotated material-transferring cylinder subject to a predetermined thickness through a metered material feeder, and at the same time extending a tape of carrier over an impression cylinder and continuously delivering said tape of carrier forwards and keeping a predetermined gap between said tape of carrier and the periphery of said material-transferring cylinder; (b) adjusting the gap between said material-transferring cylinder and said carrier for enabling said bonding agent to be transferred from said material-transferring cylinder to said tape of carrier when the gap between said material-transferring cylinder and said carrier becomes smaller than the thickness of said layer of bonding agent at the periphery of said material-transferring cylinder and, for enabling a blank area to be left in said tape of carrier when the gap between said material-transferring cylinder and said carrier becomes greater than the thickness of said layer of bonding agent at the periphery of said material-transferring cylinder; and (c) repeating step (b) so as to form the tape of carrier into a resin coated carrier having a layer of the bonding agent on one side thereof surrounded by a blank area.

The resin coated carrier fabrication apparatus comprises a frame; a rack sliderably reciprocatly mounted on said frame; a material-transferring cylinder rotatably mounted on the rack; a metered material feeder adapted for applying a layer of bonding agent to a periphery of the material-transferring cylinder according to a predetermined thickness; an impression cylinder rotatably mounted on the frame and adapted for supporting a tape of carrier; and a driving mechanism adapted for reciprocating the rack on the frame to adjust the gap between the material-transferring cylinder and the impression cylinder.

### BRIEF DESCRIPTION OF THE DRAWINGS

FIG. 1 is a schematic drawing showing a resin coated carrier fabrication apparatus according to the first embodiment of the present invention.
FIG. 2 is an enlarged view of a part of the resin coated carrier fabrication apparatus according to the first embodiment of the present invention.

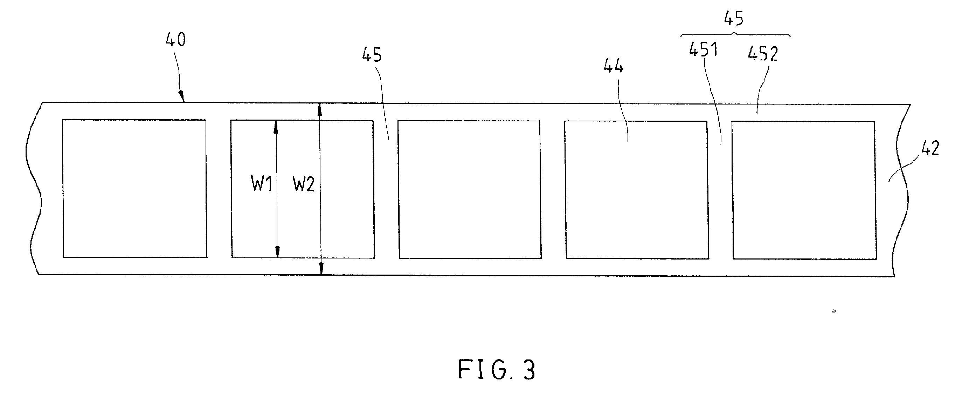

FIG. 3 is a schematic drawing showing a resin coated carrier made according to the present invention.
FIG. 4 is a schematic drawing showing a resin coated carrier fabrication apparatus according to the second embodiment of the present invention.
FIG. 5 is a schematic drawing showing a resin coated carrier fabrication apparatus according to the third embodiment of the present invention.

### DETAILED DESCRIPTION OF THE PREFERRED EMBODIMENT

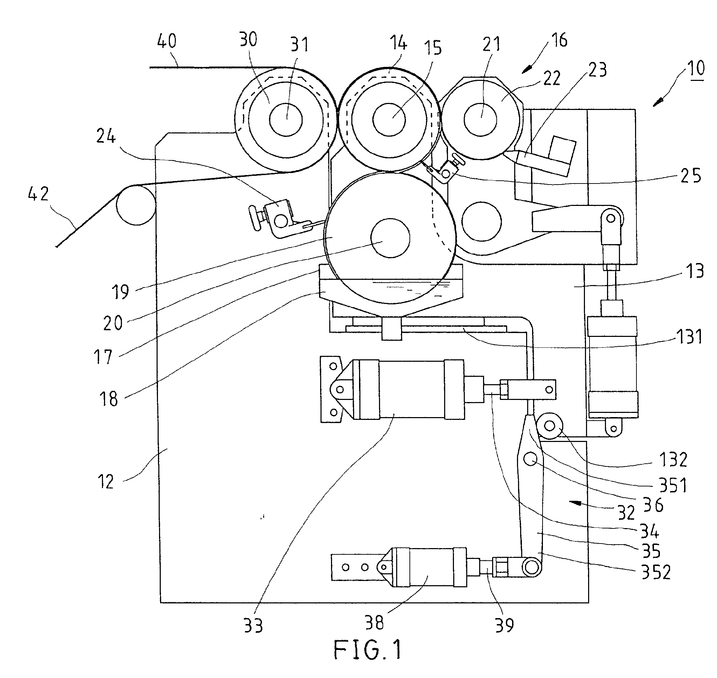

Referring to FIGS. 1∼3, a resin coated carrier fabrication apparatus **10** according to the first embodiment of the present invention is shown for fabricating a resin coated carrier **40**, which comprises a tape of carrier **42**(formed of copper foil or PET film, for example) and a layer of resin **44** coated over one side of the tape of carrier **42**, leaving a blank area **45** surrounding the layer of resin **44**. The apparatus **10** comprises a frame **12**, a material-transferring cylinder **14**, a metered material feeder **16**, an impression cylinder **30**, and a driving mechanism **32.**

The material-transferring cylinder **14** is rotatably mounted on a rack **13** by a pivot shaft **15**. The rack **13** is supported on a linear bearing **131** at the frame **12** for reciprocatly sliding. The material-transferring cylinder **14** is rotatable in counter-clockwise direction.

The metered material feeder **16** comprises a container **17** mounted on the frame **12** and adapted for holding a bonding agent **18**, an applicator **19** rotatably mounted on the frame **12** below the material-transferring cylinder **14** by a pivot shaft **20**, a scraping wheel **22** rotatably mounted on the frame **12** besides the material-transferring cylinder **14** by a pivot shaft **21**, and a scraper blade **23** mounted on the rack **13** and stopped at the periphery of the scraping wheel **22.** The bonding agent **18** is obtained from but not limited to, for example, epoxy resin. The applicator **19** is partially dipped in the bonding agent **18** and spaced from the periphery of the material-transferring cylinder **14** by a predetermined gap **d1**. When the applicator **19** rotated clockwise, it picks up the bonding agent **18** with the peripheral wall. When the thickness of the bonding agent **18** at the periphery of the applicator **19** surpasses the width of the gap **d1**, the bonding agent **18** is transferred to the periphery of the material-transferring cylinder **14**. The scraping wheel **22** is peripherally spaced from the material-transferring cylinder **14** by a predetermined gap **d2.** The scraping wheel **22** is rotated counter-clockwise to carry excessive amount of the bonding agent **18** from the material-transferring cylinder **14**, keeping the thickness of the bonding agent **18** at the periphery of the material-transferring cylinder **14** within a predetermined thickness **d2.** The scraper blade **23** is adapted to remove the bonding agent **18** from the scraping wheel **22** for recycling. By means of the aforesaid arrangement, the metered material feeder **16** applies the bonding agent **18** to the periphery of the material-transferring cylinder **14** subject to the predetermined thickness **d2.**

During fabrication, a flat scraper **24** may be mounted on the frame **12** and spaced from the periphery of the applicator **19** for removing excessive amount of the bonding agent **18** from the applicator **19,** preventing accumulation of excessive amount of the bonding agent **18** between the applicator **19** and the material-transferring cylinder **14.** The flat scraper **24** is not requisite, and can be eliminated.

The impression cylinder **30** is rotatably mounted on the frame **12** by a pivot shaft **31**, and adapted for transferring the carrier **42** forward. The impression cylinder **30** is made of elastic material, for example, rubber. When the carrier **42** extended over the periphery of the impression cylinder **30**, it is maintained spaced from the periphery of the material-transferring cylinder **14** by a gap **d3.** When the carrier **40** continuously delivered forwards, the impression cylinder **30** is rotated counter-clockwise to guide movement of the carrier **40.** Alternatively, the impression cylinder **30** can be made not rotatable because the tape of carrier **42** is delivered by other transmission means, which is not described herein in detail because it is not within the scope of the present invention.

The driving mechanism **32** comprises a first air cylinder **33**, a swivel arm **35**, and a second air cylinder **38** all mounted on said frame **12**. The first air cylinder **33** has a reciprocating rod **34** connected to the rack **13** for reciprocating the rack **13** along the linear bearing **131**. The swivel arm **35** is rotatably mounted on the frame **12** by a pivot shaft **36**, having a first end **351** stopped against the periphery of a stop rod **132** at the rack **13** and a second end **352** coupled to the reciprocating rod **39** of the second air cylinder **38**. When the reciprocating rod **39** of the second air cylinder **38** retracted, the first end **351** of the swivel arm **35** is moved to the stop rod **132** to further move the rack **13** rightwards. On the contrary, when the reciprocating rod **39** of the second air cylinder **38** extended out, the first end **351** of the swivel arm **35** is returned, and the reciprocating rod **34** of the first air cylinder **33** is retracted to move the rack **13** leftwards. Therefore, the driving mechanism **32** is capable of moving the rack **13** forwards and backwards to adjust the gap between the material-transferring cylinder **14** and the impression cylinder **30.**

In actual operation, use the metered material feeder **16** to apply the bonding agent **18** to the periphery of the material-transferring cylinder **14** subject to the predetermined thickness **d2**, and at the same time extend the tape of carrier **42** over the impression cylinder **30,** leaving a predetermined gap **d3** between the material-transferring cylinder **14** and the tape of carrier **42**, and then use the driving mechanism **32** to repeatedly adjust the gap between the material-transferring cylinder **14** and the impression cylinder **30.** When the gap between the material-transferring cylinder **14** and the tape of carrier **42** became smaller than the thickness of the bonding agent **18** (i.e., **d3<d2),** the bonding agent **18** is adhered to the tape of carrier **42.** On the contrary, when the gap between the material-transferring cylinder **14** and the tape of carrier **42** became greater than the thickness of the bonding agent **18** (i.e., **d3**>**d2**), the tape of carrier **42** is continuously delivered forwards, and the bonding agent **18** is not adhered to the tape of carrier **42**, thereby causing a blank area **45** left on one side of the tape of carrier **42.** By means of repeatedly adjust the gap between the material-transferring cylinder **14** and the impression cylinder **30**, the desired layer of resin **44** and blank area **45** are formed on one side of the tape of carrier **42**.

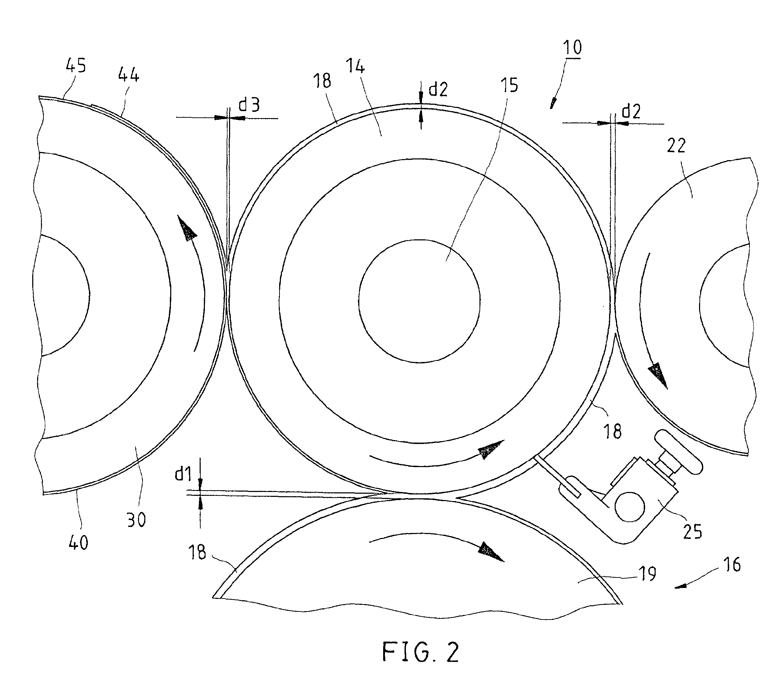

The apparatus of the present invention enables the operator to repeatedly adjust the gap between the material-transferring cylinder **14** and the impression cylinder **30**, leaving a transverse blank area **451** between each two adjacent layer of resin **44**. If desired, longitudinal blank areas **452** can be left on one side of the tape of carrier **42** along two long side edges of the tape of carrier **42.** As illustrated in FIG. 2, a pair of scrapers **25** are installed on the frame **12** and pressed on the periphery of the material-transferring cylinder **14.** The pitch **w1** of the scrapers **25** is smaller than the width **w2** of the tape of carrier **42** so that two longitudinal blank areas **452** are left on one side of the tape of carrier **42** when the bonding agent **18** applied to the tape of carrier **42** by the material-transferring cylinder **14** to form the desired layer of resin **44** of width **w1** (**w1<w2**). Alternatively, the applicator **19** or the material-transferring cylinder **14** can be made having the width **w1**. In this case, the aforesaid scrapers **25** can be eliminated. The aforesaid two designs can control the pattern of the layer of resin **44** with two longitudinal blank areas **452** left on one side of the tape of carrier **42.**

When the resin coated carrier **40** finished, it is cut into resin coated carrier units, each unit having a layer of resin **44** surrounded by a blank area **45.** When one resin coated carrier unit adhered to a substrate, the respective layer of resin **44** is partially forced to diffuse by the applied pressure. However, because a blank area **45** is provided around the layer of resin **44**, the layer of resin **44** does to flow out of the border of the resin coated carrier unit. Therefore, when using the resin-coated carrier units, it is not necessary to add a release film to the lens board.

The aforesaid driving mechanism may be various embodied. For example, the driving mechanism can be coupled to the impression cylinder and controlled to move the impression cylinder relative to the material-transferring cylinder so as to adjust the pitch between the impression cylinder and the material-transferring cylinder.

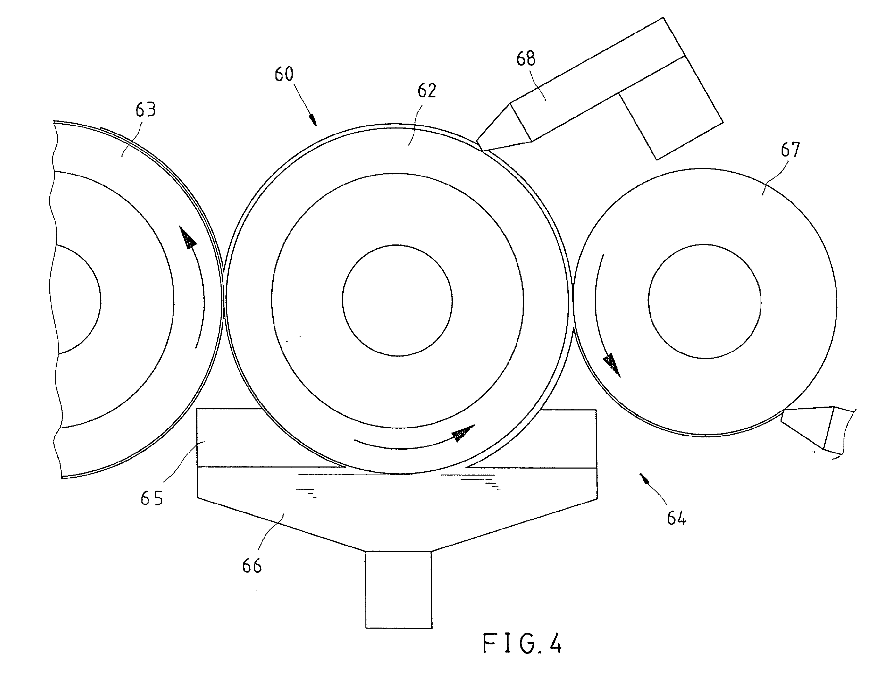

The aforesaid metered material feeder may also be variously embodied. FIG. 4 shows resin coated carrier fabrication apparatus **60** according to the second embodiment of the present invention. The resin coated carrier fabrication apparatus **60** comprises a material-transferring cylinder **62**, an impression cylinder **63**, and a metered material feeder **64**. The metered material feeder **64** comprises a container **65** holding a bonding agent **66**, a scraping wheel **67** at one side of the material-transferring cylinder **62**, and a pair of scrapers **68** pressed on the periphery of the material-transferring cylinder **62** for removing the bonding agent **66** from two opposite lateral sides of the periphery of the material-transferring cylinder **62**. This alternate form eliminates the aforesaid applicator, and enables the material-transferring cylinder **62** to directly pick up the bonding agent **66** from the container **65.** The scraping wheel **67** is adapted for removing excessive amount of the bonding agent **66** from the periphery of the material-transferring cylinder **62**. Therefore, the bonding agent **66** can be uniformly applied to the periphery of the material-transferring cylinder **62** subject to the desired thickness.

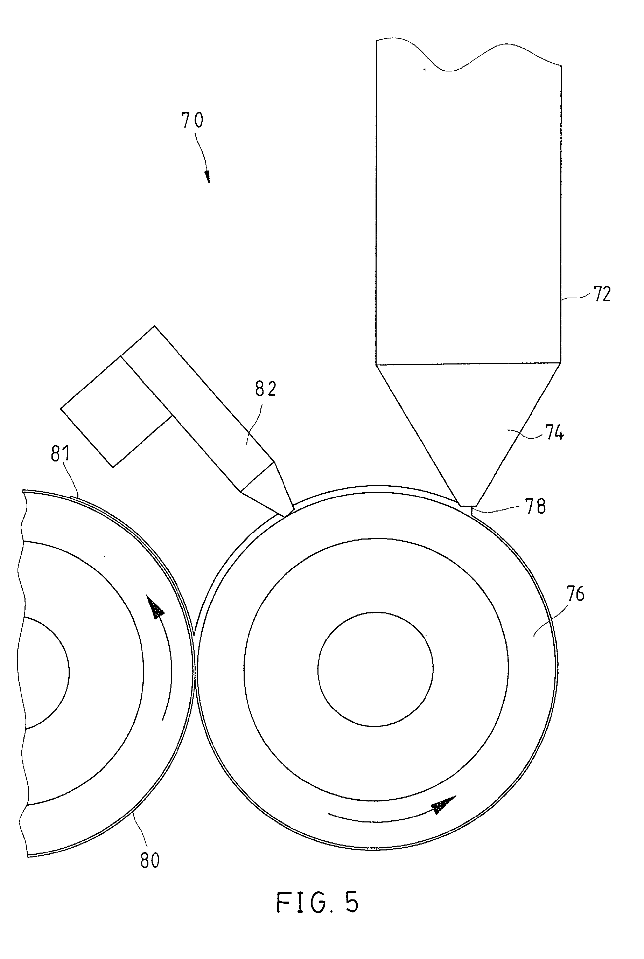

FIG. 5 shows resin coated carrier fabrication apparatus **70** according to the third embodiment of the present invention. The resin coated carrier fabrication apparatus **70** uses an electronically (or mechanically) controlled metered material feeder **72** to apply the bonding agent **74** to the periphery of the material-transferring cylinder **76** at a constant speed, enabling the bonding agent **74** to be uniformly covered over the periphery of the material-transferring cylinder **76** subject to a desired thickness. The bonding agent **74** is delivered out of a narrow elongated outlet **78** to the periphery of the material-transferring cylinder **76**. The extending direction of the outlet **78** is in parallel to the axis of the material-transferring cylinder **76.** The length of the outlet **78** can be made smaller than the width of a carrier **80**. Alternatively, two scrapers **82** may be used to remove the bonding agent from two lateral sides of the periphery of the material-transferring cylinder **76.** When the desired layer of resin **81** formed on one side of the carrier **80**, a bank area is left around the layer of resin **81**. This embodiment eliminates the use of the aforesaid applicator and scraping wheel.

Although particular embodiments of the invention have been described in detail for purposes of illustration, various modifications and enhancements may be made without departing from the spirit and scope of the invention. Accordingly, the invention is not to be limited except as by the appended claims.

## Claims

1. A resin coated carrier fabrication method comprising the steps of:
(a) applying a layer of bonding agent to a periphery of a continuously rotated material-transferring cylinder subject to a predetermined thickness through a metered material feeder, and at the same time extending a tape of carrier over an impression cylinder and continuously delivering said tape of carrier forwards and keeping a predetermined gap between said tape of carrier and the periphery of said material-transferring cylinder;
(b) adjusting the gap between said material-transferring cylinder and said carrier for enabling said bonding agent to be transferred from said material-transferring cylinder to said tape of carrier when the gap between said material-transferring cylinder and said carrier becomes smaller than the thickness of said layer of bonding agent at the periphery of said material-transferring cylinder and, for enabling a blank area to be left in said tape of carrier when the gap between said material-transferring cylinder and said carrier becomes greater than the thickness of said layer of bonding agent at the periphery of said material-transferring cylinder; and
(c) repeating step (b) so as to form said tape of carrier into a resin coated carrier having a layer of said bonding agent on one side thereof surrounded by a blank area.

2. The resin coated carrier fabrication method as claimed in claim 1, wherein said step (b) includes a sub-step of adjusting the width of said layer of bonding agent at the periphery of said material-transferring cylinder before transferring said bonding agent from said material-transferring cylinder to said carrier.

3. The resin coated carrier fabrication method as claimed in claim 1, wherein said bonding agent is a resin.

4. A resin coated carrier fabrication apparatus comprising:
a frame;
a rack sliderably reciprocatly mounted on said frame;
a material-transferring cylinder rotatably mounted on said rack;
a metered material feeder adapted for applying a layer of bonding agent to a periphery of said material-transferring cylinder according to a predetermined thickness;
an impression cylinder rotatably mounted on said frame and adapted for supporting a tape of carrier; and
a driving mechanism adapted for reciprocating said rack on said frame to adjust a gap between said material-transferring cylinder and said impression cylinder.

5. The resin coated carrier fabrication apparatus as claimed in claim 4, wherein said driving mechanism comprises a first air cylinder, a swivel arm and a second air cylinder all mounted on said frame, a reciprocating rod of said first air cylinder being mounted on said rack to reciprocate it, said swivel arm being rotatably mounted to said frame and coupled between said rack and a reciprocating rod of said second air cylinder.

6. The resin coated carrier fabrication apparatus as claimed in claim 4, wherein said metered material feeder comprises a container mounted on said frame and holding said bonding agent, an applicator mounted on said frame below said material-transferring cylinder, and a scraping wheel mounted on said rack besides said material-transferring cylinder, said applicator being partially dipped in said bonding agent and keeping a predetermined gap between said applicator and said material-transferring cylinder, said bonding agent being attached to a periphery of said applicator then applying to the periphery of said material-transferring cylinder when said applicator rotated, said scraping wheel being adapted for removing excessive amount of said bonding agent from the periphery of said material-transferring cylinder for enabling said bonding agent to be covered over the periphery of said material-transferring cylinder according to a predetermined thickness.

7. The resin coated carrier fabrication apparatus as claimed in claim 6, wherein the width of said applicator is smaller than the width of the tape of carrier to be supported on said impression cylinder.

8. The resin coated carrier fabrication apparatus as claimed in claim 6, further comprising a pair of scrapers respectively mounted on said frame and spaced from each other at a pitch smaller than the width of the tape of carrier to be supported on said impression cylinder and respectively pressed on the periphery of said applicator at two sides.

9. The resin coated carrier fabrication apparatus as claimed in claim 6, wherein the width of said material-transferring cylinder is smaller than the width of the tape of carrier to be supported on said impression cylinder.

10. The resin coated carrier fabrication apparatus as claimed in claim 6, further comprising a pair of scrapers respectively mounted on said rack and spaced from each other at a pitch smaller than the width of the tape of carrier to be supported on said impression cylinder and respectively pressed on the periphery of said material-transferring cylinder at two sides.

11. The resin coated carrier fabrication apparatus as claimed in claim 6, further comprising a flat scraper mounted on said frame and spaced from the periphery of said applicator at a pitch and adapted for removing excessive amount of said bonding agent from the periphery of said applicator for enabling said bonding agent to be covered on the periphery of said applicator subject to a predetermined thickness.

12. The resin coated carrier fabrication apparatus as claimed in claim 4, wherein said metered material feeder comprising a container holding a bonding agent in which said material-transferring cylinder is peripherally partially dipped, a scraping wheel mounted on said rack besides said material-transferring cylinder and adapted for removing excessive amount of said bonding agent from the periphery of said material-transferring cylinder.

13. The resin coated carrier fabrication apparatus as claimed in claim 12, wherein the width of said material-transferring cylinder is smaller than the width of the tape of carrier to be supported on said impression cylinder.

14. The resin coated carrier fabrication apparatus as claimed in claim 12, further comprising a pair of scrapers mounted on said rack and spaced from each other at a pitch smaller than the width of the tape of carrier to be supported on said impression cylinder and respectively pressed on the periphery of said material-transferring cylinder at two sides.

15. The resin coated carrier fabrication apparatus as claimed in claim 4, wherein said metered material feeder comprises a container holding a bonding agent, and a narrow elongated outlet extended in direction in parallel to the axis of said material-transferring cylinder and adapted for delivering said bonding agent from said container to the periphery of said material-transferring cylinder.

16. The resin coated carrier fabrication apparatus as claimed in claim 15, wherein the length of said outlet is smaller than the width of the tape of carrier to be supported on said impression cylinder.

17. The resin coated carrier fabrication apparatus as claimed in claim 15, further comprising a pair of scrapers mounted on said rack and spaced from each other at a pitch smaller than the width of the tape of carrier to be supported on said impression cylinder and respectively pressed on the periphery of said material-transferring cylinder at two sides.
